Europäisches Patentamt

European Patent Office

Office européen des brevets

(11) Publication number : **0 533 431 A1**

## (12) EUROPEAN PATENT APPLICATION

(21) Application number : **92308381.0**

(22) Date of filing : **15.09.92**

(51) Int. Cl.⁵ : **H03H 9/145, H03H 9/02**

(30) Priority : **17.09.91 GB 9119869**

(43) Date of publication of application :
**24.03.93 Bulletin 93/12**

(84) Designated Contracting States :
**DE FR IT SE**

(71) Applicant : **RACAL-MESL LIMITED**
**Lochend Industrial Estate Newbridge**
**Midlothian EH28 8LP Scotland (GB)**

(72) Inventor : **Deacon, John Maxwell**
**25 The Lennards**
**South Cerney, Cirencester, Glos (GB)**

(74) Representative : **Bibby, William Mark et al**
**Mathisen, Macara & co. The Coach House 6-8**
**Swakeleys Road**
**Ickenham Uxbridge UB10 8BZ (GB)**

(54) Surface acoustic wave (SAW) ladder transducer.

(57) A surface acoustic wave (SAW) ladder trans-
ducer has rungs (60,60') comprised of respec-
tive groups of interdigitated fingers provided on
a surface of a piezoelectric substrate. The ex-
tent of overlap between the fingers is uniform
over the length of the transducer and each
group is weighted by an amount related to the
relative spacing of the fingers in that group.

Fig.6.

EP 0 533 431 A1

This invention relates to surface acoustic wave (SAW) transducers and it relates particularly to so-called SAW ladder transducers.

SAW transducers are known devices that can be used in electronic filters and the like. Typically, they comprise a pattern of electrical conductors laid upon a substrate made from a piezoelectric material.

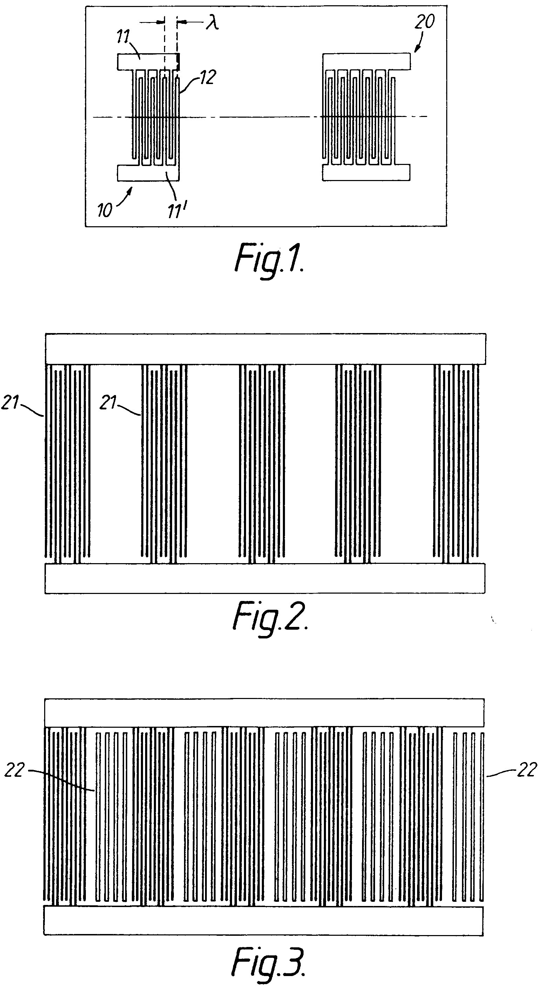

Figure 1 shows a simple form of SAW transducer, referenced 10. This transducer consists of two parallel metal contact pads 11,11″ arranged longitudinally, with narrow lateral fingers 12 extending inwardly therebetween. The fingers are interdigitated and a.c. electrical signals applied between the contact pads appear between overlapping sections of adjacent fingers causing surface acoustic waves to propagate longitudinally in the piezoelectric material. The centre frequency $f_c$ of the transducer i.e. the frequency of maximum response is related to the period $\lambda$ of the fingers i.e. the spacing between adjacent fingers having the same polarity, by the expression

$$\lambda \, f_c = v$$

where v is the velocity of surface acoustic waves in the piezoelectric material.

In general, a SAW transducer device such as an electronic filter will have two such transducers, as shown in Figure 1 - an input transducer 10 for inducing surface acoustic waves in response to received a.c. electrical input signals and an output transducer 20 for generating a.c. electrical output signals in response to surface acoustic waves induced by the input transducer 10.

Due to piezoelectric and mechanical loading of the substrate material by the fingers a small amount of the propagating surface acoustic wave will be reflected at each finger, and at the centre frequency of the transducer the reflected waves will combine constructively. This gives rise to a distortion of the transducer frequency response which becomes more pronounced as the number of fingers in the transducer is increased. As a general rule, the larger the number of fingers, the narrower will be the transducer bandwidth.

A similar problem, which occurs in relatively large transducers, is known as regeneration, an effect whereby surface acoustic waves are partially detected and then re-radiated by the interdigitated fingers. The effect of regeneration on filter performance is similar to that of reflection; however, the severity of the resulting degradation is related also to the degree of mismatch between associated transducers and their loads.

Figure 2 shows a so-called SAW ladder transducer which is often employed with a view to alleviating the problems presented by reflection and/or regeneration. As its name suggests, the fingers of a ladder transducer are arranged in discrete groups e.g. 21 at regular intervals along its length, rather like the rungs of a ladder for which the contact pads would be the uprights. This configuration has the advantage that the first order response at or near the transducer centre frequency is substantially the same as that for a transducer having the same length, but formed from a single continuous group of fingers. Accordingly, because the ladder transducer has fewer fingers, the effect of reflection and/or regeneration is greatly reduced.

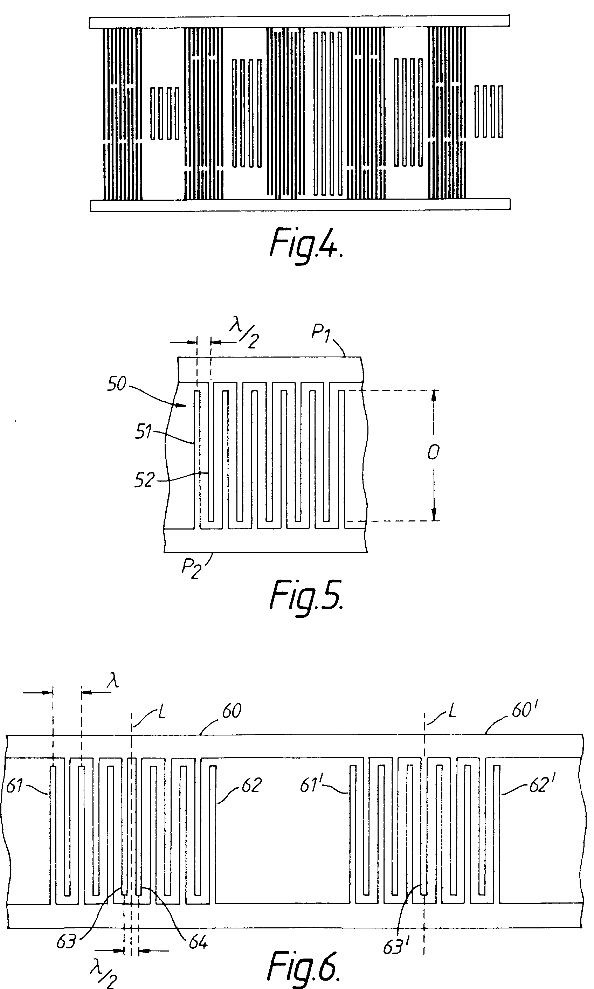

As shown in Figure 3, the ladder transducer may have the form of a single-phase uni-directional transdsucer - commonly referred to as LSPUDT. With this structure, the spaces between adjacent rungs of the ladder are at least partially filled with metal strips e.g. 22 which act as reflectors of propagating surface acoustic waves. The reflector strips are offset from their periodic positions by $\lambda/8$ causing the transducer to propagate surface acoustic waves unidirectionally - sending them preferentially to the right or left depending on the direction of the offset, the acoustic properties of the metal and of the piezoelectric substrate, and whether the strips are electrically isolated or shorted together. Insertion losses as low as a few dB's can be attained in a device consisting of two such LSPUDT's arranged in face-to-face relationship.

The ladder transducers shown in Figures 2 and 3 have fingers which are split - so-called "split fingers". Both elements of the split finger are connected to the same contact pad and have the same polarity; however, they are spaced apart by $\lambda/4$. With this arrangement, surface acoustic waves reflected at each element will be in anti-phase and will cancel thereby further reducing distortion caused by reflection. However, this technique can be unsatisfactory in that it has no effect on regeneration, it requires that each element of the split finger has a width which is less than that needed to give the most efficient electro-mechanical signal conversion and the technique also reduces the maximum possible frequency of operation. Therefore, the use of split fingers may be considered impractical for many applications. However, it will be understood that throughout this specification the term "finger" embraces "split-fingers" of the kind described.

In practice, it is customary to weight a transducer in accordance with a pre-arranged weighting profile in order to achieve a desired frequency response and hitherto this has been effected by weighting the lengths of the transducer fingers - a technique known as apodisation.

In the case of a ladder transducer each individual finger could be length-weighted by the appropriate amount or, more conveniently, the fingers could be weighted on a rung-by-rung basis, with the fingers in each rung being of equal length, as shown in Figure 4. As this Figure shows, the reflector strips can also be weighted in this manner.

Although this technique is relatively simple to implement, it has significant shortcomings. In particular, it is usually not possible to weight both the input and output transducers by this method and obtain a total frequency response which is the simple product of the individual transducer responses. For example, a filter consisting of two identical Hamming weighted apodised transducers, each having an individual stopband rejection level of 43dB, is found in practice to have a total stopband rejection level of only about 30dB, worse than that of a single transducer. Therefore, in practice, a simple SAW device would usually have one apodised transducer and one unweighted transducer. However, this could give rise to a further problem - known as apodisation loss - which occurs when there is a mismatch between the apodisation profiles of two associated transducers. Typically, apodisation loss is in the order of 1dB and so in many cases, where the total insertion loss is in the order of 20-30 dB apodisation loss is not a significant factor. However, in the case of low loss SAW devices apodisation loss could be the major contributor and may present significant problems.

It is with the aim of alleviating the aforementioned problems presented by apodisation weighting that the present invention provides a surface acoustic wave (SAW) ladder transducer having rungs each comprising a respective group of interdigitated fingers provided on a surface of a piezoelectric substrate, wherein the extent of overlap between adjacent fingers having opposite polarities is constant over the length of the transducer, each said group is weighted by an amount related to the relative spacing of the fingers in that group, and at least two of the groups are weighted by different amounts. Because the extent of overlap is constant, a transducer of the invention does not suffer from the afore-mentioned drawbacks associated with apodisation; in contrast, each group of fingers in the transducer is weighted by an amount determined not by the lengths of the fingers in that group but by their relative spacing. A further advantage of the invention, is that the fingers may all extend across the full aperture of the transducer and thereby maintain a full, uniform beam profile.

The required weight may be derived by two alternative techniques, and for convenience these will be referenced herein as 'phase-offset' weighting and 'frequency-offset' weighting.

With phase-offset weighting the relative spacing of the fingers in at least one of the groups is such as to render the fingers capable of generating (or responding to) surface acoustic waves having predetermined phase relationships whereby to weight that group by a required amount.

The at least one group may consist of at least two identical sub-groups disposed symmetrically about a reference line, the group being weighted by an amount related to the relative spacing of the at least two sub-groups. In the case of a rung consisting of two sub-groups the at least one group may be weighted by an amount

$$\cos \frac{(\pi d)}{\lambda},$$

wherein $\lambda$ is the period of the fingers in the group, and d is the centre-to-centre spacing of the fingers at neighbouring ends of the two sub-groups.

With 'frequency-offset' weighting at least one of the groups is weighted by an amount related to the centre frequency for that group, the centre frequency being determined by the period of the fingers in the group. In a particular embodiment the at least one group is weighted by an amount

$$A = \frac{\sin x}{x}$$

where

$$x = \frac{1}{2} N\pi \frac{(f_o - f_c)}{f_c},$$

$f_o$ is the operating frequency for the transducer, and

N is the number of fingers in the group.

It will be appreciated that both techniques - "phase offset" weighting and "frequency offset" weighting - could be applied to different groups within the same transducer.

A respective group of parallel reflective strips may be provided on the substrate in the space or spaces between one or more pairs of adjacent rungs, and the transducer may be a single phase unidirectional ladder transducer (LSPUTD). The or each group of respective strips in the transducer may also be weighted by phase and/or frequency offset weighting.

A SAW ladder transducer in accordance with the invention may be used as the input transducer and/or the output transducer of a SAW transducer device, such as a SAW filter. A SAW ladder transducer in accordance with the invention could, for example, be combined with an apodised SAW transducer, and because the former has a uniform overlap profile the total frequency response of the device would be given by the simple product of the frequency responses of the two transducers. Apodisation loss would still occur, however, and this could be eliminated by using two identical SAW ladder transducers in accordance with the invention.

SAW ladder transducers in accordance with the invention are now described, by way of example only, with reference to the accompanying drawings, in which:

Figure 1 shows a known SAW transducer device having an input transducer and an output transducer;

Figure 2 shows a known SAW ladder transducer;

Figure 3 shows a known single-phase unidirectional ladder transducers (LSPUDT);

Figure 4 shows a known apodised LSPUDT;

Figure 5 is a detailed illustration of a single rung in a SAW ladder transducer;
Figure 6 shows two rungs in a SAW ladder transducer in accordance with the invention, and illustrates the 'phase-offset' weighting technique;
Figure 7 shows another SAW ladder transducer in accordance with the invention, and illustrates the 'frequency-offset' weighting technique; and
Figures 8(a), 8(b) and 8(c) illustrate how 'phase offset' weighting can be applied to a group of reflector strips.

Figure 5 gives a detailed illustration of a single rung in a SAW ladder transducer.

The transducer comprises a pair of parallel contact pads $P_1, P_2$ extending longitudinally, and each rung, such as that shown in Figure 5, consists of a respective group of lateral fingers 50 extending inwardly therebetween.

The fingers have an interdigitated configuration such that adjacent fingers (e.g. 51,52) are connected to different contact pads and are disposed in overlapping relationship, the region of overlap being referenced 0. With this configuration, the fingers of each overlapping pair will have opposite polarities when the transducer is energised.

As already explained, it is customary to weight the rungs of a SAW ladder transducer by different amounts to attain a desired frequency response, and, hitherto, it has been necessary to weight the length of individual fingers, or groups of fingers.

By contrast, the transducer of this invention has fingers which are all the same length so that the extent of overlap between adjacent finger pairs is constant over the entire length of the transducer, and each group of fingers is weighted by an amount determined by the relative spacing of the fingers in that group.

The required weighting can be determined by two different techniques, referred to herein generally as "phase-offset" weighting and "frequency-offset" weighting.

Phase-Offset Weighting

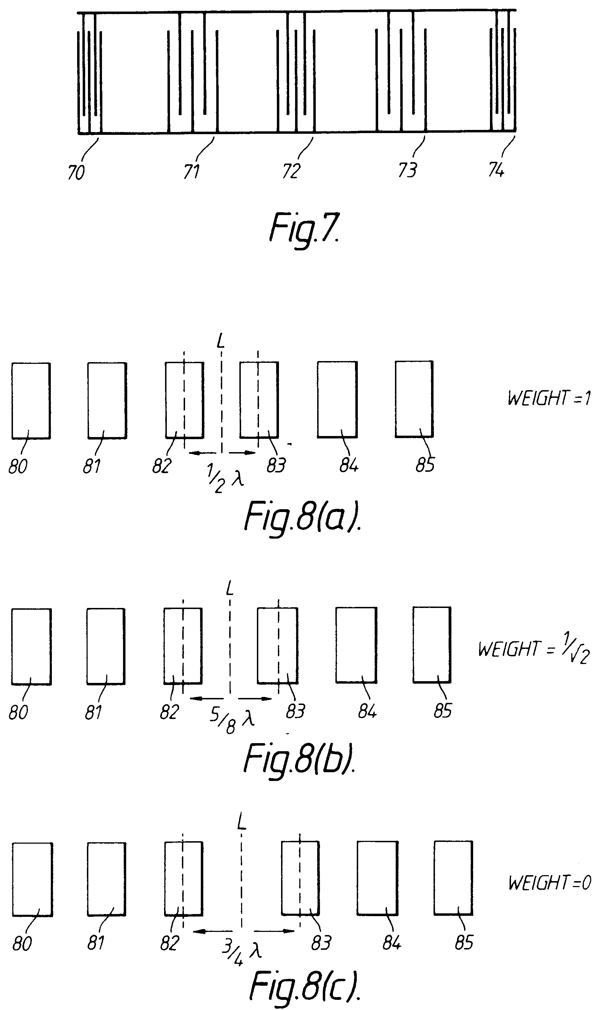

Phase-offset weighting is described with reference to Figures 6. This Figure shows two rungs 60,60' forming part of a SAW ladder transducer, and each rung consists of a respective group of interdigitated fingers. As explained with reference to Figure 5, the extent of overlap 0 between adjacent fingers having opposite polarities is uniform over the entire length of the transducer.

The two groups of fingers are weighted by different amounts. Each weight is determined by the relative spacing of the fingers in the respective group and, to that end, the fingers in each group are so arranged that they can generate (or respond to) surface acoustic waves having a predetermined phase relationship.

In the case of rung 60, the fingers are arranged in two identical sub-groups 61,62 disposed symmetrically about a reference line L and the spacing d between the two sub-groups, given by the centre-to-centre spacing of the respective fingers 63,64 at neighbouring ends of the sub-groups, is $\lambda/2$ - where $\lambda$ is the period of the fingers each sub-group. With this configuration, surface acoustic waves generated (or detected) by the fingers in the sub-groups 61,62 will be in exact anti-phase causing their destructive interference. Therefore, rung 60 has zero weight.

By contrast, the two sub-groups 61',62' of rung 60' share a common finger 63'. In effect, the fingers at neighbouring ends of the sub-groups overlap each other and so the sub-groups have zero spacing. With this configuration, surface acoustic waves generated (or detected) by the fingers in the sub-groups are exactly in phase giving a weight of unity.

The phase difference between surface acoustic waves generated (or detected) by the fingers of the two sub-groups increases progressively as their spacing d is increased from 0 (the in-phase condition) to $\lambda/2$ (the out-of-phase condition), giving rise to a corresponding attenuation of the net amplitude of the waves. It will be appreciated, therefore, that the spacing d between the sub-groups can be set at any value in the range 0 to $\lambda/2$ to give a corresponding weight in the range 1 to 0. In general, the weight W will be related to the spacing d between the sub-groups by the expression:

$$W = \cos \frac{(\pi d)}{\lambda} \quad (2)$$

Negative weights can also be obtained by either reversing the polarities of the fingers or alternatively increasing the spacing d between the sub-groups to beyond $\lambda/2$.

It will be understood that although this embodiment of the invention has been described with reference to rungs having two sub-groups, more than two sub-groups could alternatively be used.

It will be appreciated that, in general, a SAW ladder transducer could, and probably would, have many more than two rungs, and each rung would have one of a range of different weights whereby to attain the desired frequency response for the transducer.

Frequency-Offset Weighting

Frequency-offset weighting is described with reference to Figure 7. This Figure shows a SAW ladder transducer having five rungs 70,71 ... 74, each comprising a respective group of interdigitated fingers. As before, the extent of overlap between adjacent fingers of opposite polarity is constant over the length of the transducer.

In this particular embodiment, a first weight $W_1$ is applied to rungs 70,74, a second weight $W_2$ is applied to rungs 71,73 and a third weight $W_3$ is applied to rung 72. The three weights are all different and, as will become clear, each weight is related to the centre frequency $f_c$ of the group to which it is applied which, in turn, is determined by the period of the fingers in that group.

This can be illustrated by considering the frequency response of a group N fingers, at a frequency f say. The amplitude of the frequency response is given by the expression:

$$\frac{\sin x}{x}$$

where

$$x = N\pi\frac{(f - f_c)}{f_c}$$

Therefore, if the transducer is required to operate at a frequency $f_o$ (the centre frequency of the transducer, for example) the $i^{th}$ group of fingers in the transducer could be weighted by an amount $A_i$, say, by offsetting the centre frequency $f_i$ of that group, relative to the operating frequency $f_o$, in accordance with the expression:

$$A_i = \frac{\sin x'}{x'} \quad (3)$$

where

$$x' = \tfrac{1}{2} N\pi\frac{(f_i - f_o)}{f_i},$$

and the required centre frequency $f_i$, as determined by this expression, would be given by setting the period $\lambda_i$ for the group in accordance with equation (1) above.

In general, there will be two values of $f_i$ satisfying equation (3), one above $f_o$ and one below, and it makes little difference to the in-band response which value is used. However, with an arrangement such as that shown in Figure 7, the "high" and "low" values of $f_i$ could be applied alternately, or alternatively psuedo randomly, to successive rungs along the transducer.

It will be understood that rungs in a SAW ladder could all be weighted using either the phase-offset technique, described with reference to Figure 6, or the frequency-offset technique, described with reference to Figure 7. Alternatively, however, both these techniques could be applied to different rungs in the same transducer.

The techniques described with reference to Figures 6 and 7 can also be applied to groups of reflector strips provided in the inter-rung spaces of a LSPUDT; however, smaller phase and frequency shifts are required.

Figures 8(a) to 8(c) illustrate how phase-offset weighting can be applied to a group of six reflector strips 80,81 ... 85. As before, the reflector strips have a uniform overlap and are arranged in two identical sub-groups disposed symmetrically to either side of a reference line L.

In Figure 8(a), the reflector strips are arranged periodically with a pitch $\lambda/2$, wherein $\lambda$ is the period of the transducer fingers. With this configuration surface acoustic waves reflected at both groups of strips are in phase giving the maximum reflection coefficient 6r (where r is the reflection coefficient for a single strip) and a weight unity.

In Figure 8(b), the spacing of the two sub-groups is increased by $\lambda/8$. This introduces a phase shift of $\pi/4$ between surface acoustic waves reflected at the strips of the two sub-groups giving a reduced net reflection coefficient of $6/\sqrt{2}r$ and a weight of $1/\sqrt{2}$.

In Figure 8(c) the spacing of the sub-groups is increased by $\lambda/4$. In this case, surface acoustic waves reflected at the strips in the two sub-groups are in exact anti-phase causing their cancellation and giving zero-weight. It will be apparent that the phase shift that needs to be applied to the reflector strips to give exact cancellation is only half that applied to the fingers of the transducer (Figure 7), and in general the weight is given by

$$\cos \pi \left(\frac{2d}{\lambda} - 1\right).$$

Similarly, in the case of frequency-offset weighting, the frequency offset needed to give cancellation on reflection is half that required for the fingers of the transducer. By analogy to equation 3 above, a group of N reflector strips can be weighted by an amount $A_r$, say, by offsetting the centre frequency $f_r$ for the group in accordance with the expression

$$A_r = \frac{\sin x_r}{x_r}$$

where

$$x_r = \tfrac{1}{2} N\pi\frac{(f_r - f_o)}{2f_r}$$

and $f_o$ is the operating frequency of the transducer.

A SAW ladder transducer as described can be used as the input transducer and/or the output transducer of a SAW device, such as a SAW filter. A transducer weighted by the phase and/or offset weighting techniques, as described, could be combined with an apodised SAW transducer and because the former has a uniform overlap profile the total frequency response of the device would be given by the simple product of the two transducers. Apodisation loss would still occur. However, this could be effectively eliminated by using two identical SAW ladder transducers weighted in accordance with the invention, one as the input transducer and the other as the output transducer.

**Claims**

1. A surface acoustic wave (SAW) ladder transducer having rungs each comprising a respective group of interdigitated fingers provided on a surface of a piezoelectric substrate, wherein the extent of overlap between adjacent fingers having opposite polarities is constant over the length of the transducer, each said group is weighted by an amount related to the relative spacing of the fingers in that group, and at least two of the groups are weighted by different amounts.

2. A transducer as claimed in claim 1, wherein the relative spacing of the fingers in at least one of the groups is such as to render the fingers capable of generating (or responding to) surface acoustic waves having predetermined phase relationships whereby to weight that group by a required amount.

3. A transducer as claimed in claim 2, wherein the at least one group consists of at least two identical sub-groups disposed symmetrically about a reference line, the group being weighted by an amount related to the relative spacing of the at least two sub-groups.

4. A transducer as claimed in claim 3, wherein the at least one group comprises two sub-groups and is weighted by an amount

$$\cos\left(\frac{\pi d}{\lambda}\right),$$

where $\lambda$ is the period of the fingers in the group, and d is the centre-to-centre spacing of the fingers at neighbouring ends of the two sub-groups.

5. A transducer as claimed in claim 4, wherein the two sub-groups include a common finger centred on the reference line, whereby the relative spacing of the sub-groups is zero and the weight is unity.

6. A transducer as claimed in claim 1, wherein at least one of the groups is weighted by an amount related to the centre frequency for that group, the centre frequency being determined by the period of the fingers in the group.

7. A transducer as claimed in claim 6, wherein the at least one group is weighted by an amount A related to the centre frequency $f_c$ for that group by the expression:

$$A = \frac{\sin x}{x}$$

wherein

$$x = \frac{1}{2} N\pi \frac{(f_o - f_c)}{f_c},$$

$f_o$ is the operating frequency for the transducer and N is the number of fingers in the group.

8. A transducer as claimed in claim 7, wherein the operating frequency $f_o$ is the transducer centre frequency.

9. A transducer as claimed in any one of claims 1 to 8, including a respective group of parallel reflector strips provided on the substrate in the space or spaces between one or more pairs of adjacent rungs.

10. A transducer as claimed in claim 9, wherein the reflector strips are all the same length and at least one said group of reflector strips is weighted by an amount related to the relative spacing of the reflector strips in that group.

11. A transducer as claimed in 10, wherein the spacing of reflector strips in at least one of the sub-groups is such that the strips of that sub-group are capable of reflecting surface acoustic waves having predetermined relative phases.

12. A transducer as claimed in claim 11, wherein the at least one group of reflector strips consists of at least two identical sub-groups disposed symmetrically about a centre line, and the group being weighted by an amount related to the relative spacing of the at least two sub-groups.

13. A transducer as claimed in claim 12, wherein the at least one group comprises two sub-groups of reflector strips and is weighted by an amount $\cos \pi \left(\frac{2d}{\lambda} - 1\right)$ wherein $\lambda$ is the period of the strips in the group and d is the centre-to-centre spacing of the strips at neighbouring ends of the two sub-groups.

14. A transducer as claimed in claim 10, wherein the at least one group of reflector strips is weighted by an amount related to the centre frequency for that group, the centre frequency being determined by the period of the reflector strips in the group.

15. A transducer as claimed in claim 14, wherein the at least one group of reflector strips is weighted by an amount A′ related to the centre frequency $f_c'$ for that group by the expression

$$A' = \frac{\sin x'}{x'}$$

where

$$x' = \frac{1}{2} N'\pi \frac{(f_o - f_c')}{2f_c'}$$

and N′ is the number of reflector strips in the group.

16. A surface acoustic wave (SAW) transducer device comprising an input SAW transducer and an output SAW transducer, and wherein the input and/or the output transducer is a SAW ladder transducer as claimed in any one of claims 1 to 15.

17. A transducer device as claimed in claim 16, wherein the input and output transducers comprise identical SAW ladder transducers as claimed in any one of claims 1 to 15.

Fig.1.

Fig.2.

Fig.3.

Fig.4.

Fig.5.

Fig.6.

Fig.7.

WEIGHT = 1

Fig.8(a).

WEIGHT = $\frac{1}{\sqrt{2}}$

Fig.8(b).

WEIGHT = 0

Fig.8(c).

European Patent Office

**EUROPEAN SEARCH REPORT**

Application Number

EP 92 30 8381

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X | EP-A-0 089 617 (SIEMENS) 8 May 1985 * page 14, line 16 - page 17, line 16; figures 5-8 * | 1,2,3 | H03H9/145 H03H9/02 |
| A | ELECTRONICS LETTERS. vol. 9, no. 6, 22 March 1973, ENAGE GB pages 138 - 140 M.F.LEWIS 'SURFACE-ACOUSTIC-WAVE FILTERS EMPLOYING SYMMETRIC PHASE WEIGHTED TRANSDUCERS' * the whole document * | 5 | |
| A | IEEE TRANSACTIONS ON SONICS AND ULTRASONICS vol. 24, no. 2, March 1977, NEW YORK US pages 94 - 101 H.A.HAUS ET AL 'TRANSMISSION RESPONSE OF CASCADED GRATINGS' * page 98, column 1, line 13 - page 100, column 2, line 37; figures 6-11 * | 9-12,14 | |
| A | IEEE TRANSACTIONS ON ULTRASONICS FERROELECTRICS AND FREQUENCY CONTROL vol. 37, no. 2, March 1990, NEW YORK (US) pages 116 - 117 , XP000125777 C.B.SAW ET AL 'SAMPLING EFFECT OF DISTRIBUTED REFLECTOR ARRAYS WITHIN A SINGLE-PHASE UNIDIRECTIONAL SAW TRANSDUCER' * the whole document * | 9 | TECHNICAL FIELDS SEARCHED (Int. Cl.5 ) H03H |

The present search report has been drawn up for all claims

| Place of search | Date of completion of the search | Examiner |
|---|---|---|
| THE HAGUE | 23 NOVEMBER 1992 | COPPIETERS C. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)